Europäisches Patentamt

European Patent Office

Office européen des brevets

(19)

(11) Veröffentlichungsnummer : **0 166 953**
**B1**

(12) **EUROPÄISCHE PATENTSCHRIFT**

(45) Veröffentlichungstag der Patentschrift :
28.09.88

(51) Int. Cl.⁴ : **G 01 N 24/04**, G 01 N 24/08

(21) Anmeldenummer : 85106457.6

(22) Anmeldetag : 24.05.85

(54) Kernspin-Tomographiegerät.

(30) Priorität : 07.06.84 DE 3421291

(43) Veröffentlichungstag der Anmeldung :
08.01.86 Patentblatt 86/02

(45) Bekanntmachung des Hinweises auf die Patenterteilung : 28.09.88 Patentblatt 88/39

(84) Benannte Vertragsstaaten :
DE FR GB NL

(56) Entgegenhaltungen :
EP-A- 0 073 375
EP-A- 0 073 614
EP-A- 0 107 238
GB-A- 1 433 397
GB-A- 2 126 727
US-A- 4 095 168
REVIEW OF SCIENTIFIC INSTRUMENTS, Band 52, Nr.
4, April 1981, Seiten 542-547, New York, US; J.
BRONDEAU et al.: "Flexible fourier multinuclear
magnetic resonance spectrometer"

(73) Patentinhaber : Siemens Aktiengesellschaft Berlin
und München
Wittelsbacherplatz 2
D-8000 München 2 (DE)

(72) Erfinder : Freisen, Ludger
Heinrich-Hertz-Strasse 13
D-8520 Erlangen (DE)
Erfinder : Kess, Helmut
Spardorfer Strasse 5
D-8520 Erlangen (DE)
Erfinder : Krause, Norbert, Dr.
Weinbergstrasse 29
D-8551 Heroldsbach (DE)
Erfinder : Meissner, Ralph
Paul-Gossen-Strasse 34
D-8520 Erlangen (DE)

## Beschreibung

Die Erfindung betrifft ein Kernspin-Tomographiegerät zur bildlichen Darstellung von Teilbereichen aus dem Innern eines Untersuchungsobjektes mit Spulen zum Anlagen von magnetischen Grund- und Gradientenfeldern an das Untersuchungsobjekt und einer Antenne zum Erfassen der Auslenkung der Atomkerne des Untersuchungsobjektes aus ihrer Gleichgewichtslage durch hochfrequente, magnetische Anregungsimpulse.

Ein Gerät dieser Art ist in der deutschen Patentanmeldung DE-A-31 35 335 beschrieben. Dieses Gerät eignet sich dazu, die Wasserstoffatomkerne des Untersuchungsobjektes auszulenken und deren Zurückschwingen in die Gleichgewichtslage zu erfassen.

Es besteht der Wunsch, nicht nur Protonenbilder, sondern auch Bilder mit anderen Kernen, z.B. Phosphor, anzufertigen. Dies ist möglich, wenn jeweils Hochfrequenzantennen mit großen homogenen Bereichen des magnetischen Wechselfeldes und unterschiedlichen Frequenzen benutzt werden. Die Resonanzfrequenz für die Protonenbildgebung liegt beispielsweise bei 64 MHz und die Resonanzfrequenz für die Bildgebung mit Phosphorkernen bei 26 MHz. Demgemäß sind für die Erzeugung von Bildern unterschiedlicher Kerne Antennen mit unterschiedlichen Arbeitsfrequenzen erforderlich.

Der Erfindung liegt die Aufgabe zugrunde, ein Kernspin-Tomographiegerät der eingangs genannten Art so auszubilden, daß ohne Antennenwechsel eine Anregung unterschiedlicher Kerne möglich ist.

Diese Aufgabe ist erfindungsgemäß dadurch gelöst, daß die Antenne von zwei ineinandergeschachtelten Einzelantennen für unterschiedliche Frequenzen gebildet ist, von denen jede parallele Stäbe aufweist, welche an ihren Enden miteinander leitend verbunden sind. Bei dem erfindungsgemäßen Kernspin-Tomographiegerät wird das Untersuchungsobjekt käfigartig von den beiden ineinandergeschachtelten Einzelantennen umgeben, von denen jede individuell eingeschaltet und zur Messung benutzt werden kann. Es sind demgemäß die Auslenkung und Messung bei zwei verschiedenen Frequenzen möglich. Diese Frequenzen können vorzugsweise 64 MHz für die Protonenspektroskopie und Protonenbildgebung und 26 MHz für die Phosphorspektroskopie und die Phosphorbildgebung sein.

Ein Kernspinresonanzgerät, das ohne Antennenwechsel eine Anregung unterschiedlicher Kerne ermöglicht ist aus GB-A-1 433 397 bekannt. Ausserdem ist aus EP-A-0 073 375 eine insbesondere zur Zeugmatographie anwendbare Kernspinresonanz-Apparatur, die eine mit mehreren parallelen Stäber vorgesehene Antenne aufweist, bekannt.

Die Erfindung ist nachfolgend anhand der Zeichnung näher erläutert. Es zeigen :

Fig. 1 ein Kernspin-Tomographiegerät zur Erläuterung des Erfindungsgedankens, und

Fig. 2 eine Antenne eines erfindungsgemäßen Kernspin-Tomographiegerätes.

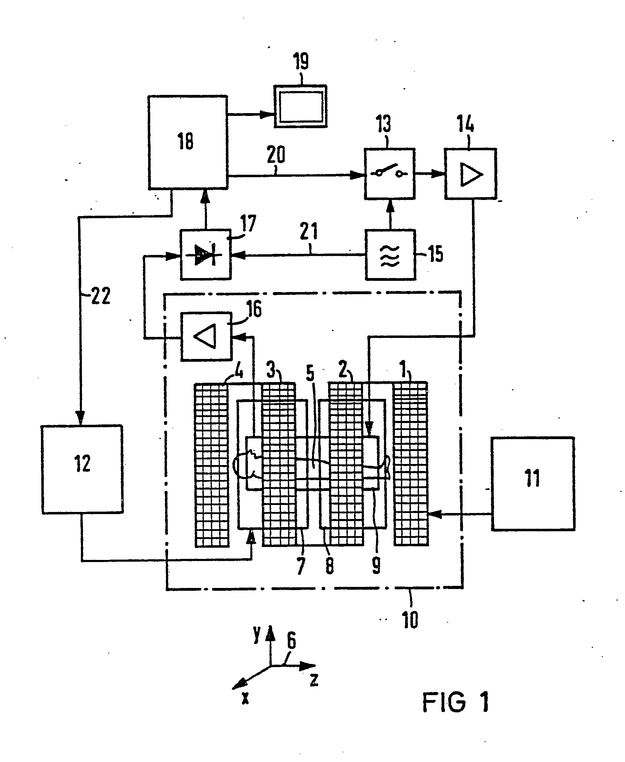

In der Figur 1 sind mit 1 und 2 sowie 3 und 4 Spulen gekennzeichnet, mit welchen ein magnetisches Gleichfeld $B_0$ erzeugt wird, in welchem sich bei Anwendung zur medizinischen Diagnostik der zur untersuchende Körper 5 eines Patienten befindet. Diesem sind außerdem Gradientenspulen zugeordnet, die zur Erzeugung unabhängiger, zueinander senkrechter Magnetfeldgradienten der Richtungen x, y und z gemäß der Andeutung in 6 vorgesehen sind. In der Figur 1 sind der Übersichtlichkeit halber nur Gradientenspulen 7 und 8 gezeichnet, die zusammen mit einem Paar gegenüberliegender, gleichartiger Gradientenspulen zur Erzeugung eines x-Gradienten dienen. Die gleichartigen, nicht gezeichneten y-Gradientenspulen liegen parallel zum Körper 5 und oberhalb sowie unterhalb von ihm und die für das z-Gradientenfeld quer zu seiner Längsachse am Kopf- und am Fußende. Die Anordnung enthält außerdem noch eine zur Anregung der Kernresonanz und Aufnahme der Kernresonanzsignale dienende Antenne 9.

Die von einer strichpunktierten Linie 10 umgrenzten Komponenten 1 bis 9 stellen das eigentliche Untersuchungsinstrument dar. Es wird von einer elektrischen Anordnung aus betrieben, die ein Netzgerät 11 zum Betrieb der Spulen 1 bis 4 sowie eine Gradientenstromversorgung 12, an welcher die Gradientenspulen 7 und 8 sowie die weiteren Gradientenspulen liegen, umfaßt. Die sowohl zur Anregung als auch zur Aufnahme des Signales dienende Antenne 9 liegt einerseits über einen Modulator 13 und einen Sendeverstärker 14 an einem Hochfrequenzoszillator 15 und andererseits über einen Signalverstärker 16 und einen phasenempfindlichen Gleichrichter 17 an einem Prozeßrechner 18, von dem aus zur Ausgabe der Abbildung ein Bildschirmgerät 19 versorgt wird. Zur Steuerung der Andordnung sind außerdem noch Verbindungen 20, 21 und 22 zwischen dem Rechner 18 und dem Modulator 13 sowie dem Oszillator 15 und dem Gleichrichter 17 sowie dem Rechner 18 und der Gradientenstromversorgung 12 vorgesehen. Die prinzipielle Wirkungsweise eines Gerätes der Figur 1 ist in der deutschen Offenlegungsschrift DE-A-31 35 335 beschrieben.

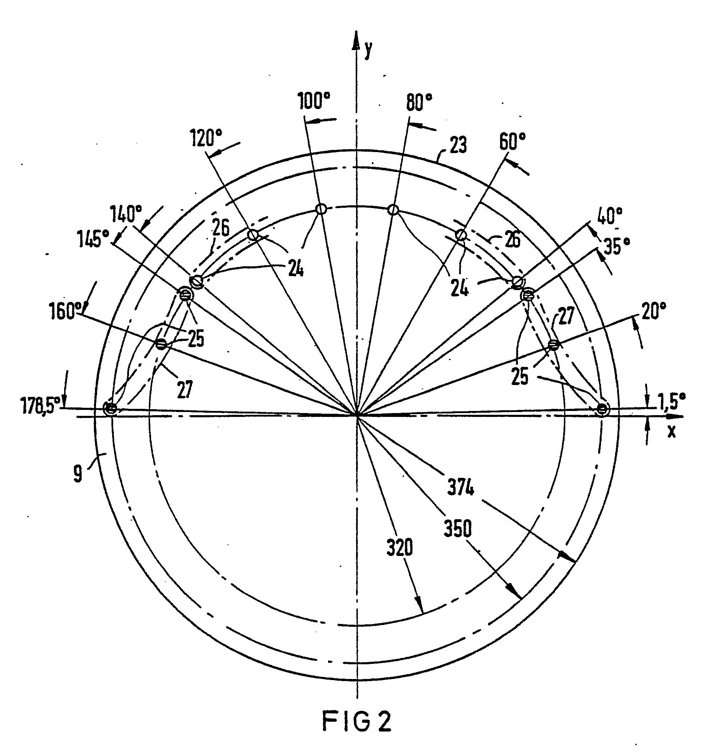

Die Figur 2 zeigt die in einer Öffnung 23 des Gerätes angeordnete Antenne 9 genauer. Aus der Figur 2 geht hervor, daß die Antenne 9 von zwei ineinandergeschachtelten Einzelantennen für unterschiedliche Frequenzen gebildet ist, von denen jede parallele Stäbe 24 bzw. 25 aufweist, welche an ihren Enden durch Leiter 26 bzw. 27 miteinander verbunden sind. Die aus den Stäben 24 bestehende Einzelantenne ist dabei eine Antenne für 64 MHz. Die Stäbe 25 bilden eine Einzelantenne für 26 MHz. In der Figur 2 sind die Stäbe 24, 25 symmetrisch zur X-Achse angeordnet und für den unteren Teil nicht gezeichnet. Ihre Versetzung ist in Winkelgraden angegeben. Zur Unterscheidung der Stäbe 24 von den Stäben 25 sind die Stäbe 24 als Kreise und die Stäbe 25 schraffiert gezeichnet. Die Radien, auf denen die Stäbe 24, 25 liegen, sind in der Figur 2 in Millimetern angegeben. Der Stabdurchmesser beträgt vorzugsweise 10 mm.

Die beiden Einzelantennen können im Hinblick auf die Anordnung der Leiter (Stäbe) gleichartig oder unterschiedlich ausgeführt sein. Auf diese Weise kann der Homogenitätsbereich der Einzelantennen geformt und der speziellen Aufgabe angepaßt werden. Die Figur 2 zeigt eine Ausführung mit hoher Homogenität des 64 MHz-Systems und geringerer Homogenität des .26 MHz-Systems.

Die Stäbe 24, 25 der Einzelantennen umgeben den in der Öffnung 23 liegenden Patienten wie ein Käfig.

## Patentansprüche

1. Kernspin-Tomographiegerät zur bildlichen Darstellung von Teilbereichen aus dem Innern eines Untersuchungsobjektes (5) mit Spulen (1 bis 4, 7, 8) zum Anlegen von magnetischen Grund- und Gradientenfeldern an das Untersuchungsobjekt (5) und einer Antenne (9) zum Erfassen der Auslenkung der Atomkerne des Untersuchungsobjektes (5) aus ihrer Gleichgewichtslage durch hochfrequente, magnetische Anregungsimpulse, dadurch gekennzeichnet, daß die Antenne (9) von zwei ineinandergeschachtelten Einzelantennen für unterschiedliche Frequenzen gebildet ist, von denen jede parallele Stäbe (24, 25) aufweist, welche an ihren Enden miteinander leitend verbunden sind.

2. Kernspin-Tomographiegerät nach Anspruch 1, dadurch gekennzeichnet, daß die eine Einzelantenne für eine Frequenz von etwa 64 MHz und die andere für eine Frequenz von etwa 26 MHz ausgebildet ist.

## Claims

1. Nuclear spin tomography device for displaying images of parts of areas of the inside of a subject being examined (5) with coils (1 to 4, 7, 8) for setting up a fundamental magnetic field and a field gradient on the subject being examined (5) and with an antenna (9) for detecting the deviation from the position of equilibrium of the atomic nuclei of the subject being examined (5) using high frequency magnetic excitation impulses, characterised in that the antenna (9) is formed of two individual antennas for different frequencies connected to each other, the antennas having respective parallel rods (24, 25) which are conductively connected together at their ends.

2. Nuclear spin tomography device according to claim 1, characterised in that one of the individual antennas is designed for a frequency of about 64 MHz and the other is designed for a frequency of about 26 MHz.

## Revendications

1. Appareil de tomographie à spin nucléaire pour la représentation par imagerie de zones partielles de l'intérieur d'un objet (5) soumis à examen, avec des bobines (1 à 4, 7, 8) destinées à appliquer audit objet (5) des champs de base et des champs irrotationnels et avec une antenne (9) pour saisir la déviation des noyaux atomiques de l'objet (5) soumis à examen, à partir de leur position d'équilibre au moyen d'impulsions d'excitation magnétiques haute fréquence, caractérisé par le fait que l'antenne (9) est constituée par deux antennes individuelles emboîtées l'un dans l'autre et destinées à des fréquences différentes, chacune de ces antennes individuelles comportant des tiges parallèles (24, 25) reliées à conduction par leurs extrémités.

2. Appareil de tomographie à spin nucléaire selon la revendication 1, caractérisé par le fait que l'une des deux antennes individuelles est réalisée pour une fréquence d'environ 64 MHz et l'autre pour une fréquence d'environ 26 MHz.

FIG 1

FIG 2